# EUROPEAN PATENT APPLICATION

(11) **EP 4 794 513 A1**
(43) Date of publication of application: **19.08.2026**
(21) Application number: 26156264.9
(22) Date of filing: 04.02.2026
(51) Int. Cl.: H10W 46/00, H10W 76/12, H10W 90/00

(54) **A METHOD FOR INCREASING PIN ALIGNMENT ACCURACY FOR A POWER SEMICONDUCTOR MODULE**

(30) Priority: 17.02.2025 US 202519055218
(71) Applicant: Infineon Technologies AG, 85579 Neubiberg (DE)
(72) Inventor: LUDWIG, Marco, 58739 Wickede/ Ruhr (DE)
(74) Representative: Westphal, Mussgnug & Partner, Patentanwälte mbB

(57) **Abstract**

A method for increasing overall pin alignment accuracy for a power semiconductor module having a plurality of pins includes attaching the plurality of pins and one or more power semiconductor dies to a first side of a substrate to form a power semiconductor subassembly; aligning a distal end of each of the pins with an alignment feature of an electrically insulative housing using a jig; and after the aligning, attaching the housing to the power semiconductor subassembly. The housing is attached to the subassembly such that the housing and the substrate together define an interior space in which the pins and the one or more power semiconductor dies are disposed. The pins jut out beyond the housing.

## Description

### BACKGROUND

Demand for electronic modules for power applications, commonly referred to as power semiconductor modules, continues to increase rapidly across a wide range of industries, including automotive, consumer electronics, renewable energy, manufacturing, and medical, among many others. Developments in semiconductor materials such as silicon carbide (SiC) and gallium nitride (GaN) have enabled such power semiconductor modules to be manufactured with advantageous features such as smaller footprint, higher voltage and current capabilities, and faster switching speeds. Many applications have specific dimensional requirements and tolerances for features of the power semiconductor module that are used to assemble and/or interface the power semiconductor module with other components. A power semiconductor module that does not meet these requirements and tolerances may require manual handling during assembly of the power semiconductor module and a component or may even be deemed unusable for the given application.

Thus, there is a need for a solution that improves the alignment accuracy of features of a power semiconductor module that interface with another component.

### SUMMARY

According to an embodiment of a method for increasing overall pin alignment accuracy for a power semiconductor module having a plurality of pins, the method comprises: attaching the plurality of pins and one or more power semiconductor dies to a first side of a substrate to form a power semiconductor subassembly; aligning a distal end of each of the pins with an alignment feature of an electrically insulative housing using a jig; and after the aligning, attaching the housing to the power semiconductor subassembly such that the housing and the substrate together define an interior space in which the pins and the one or more power semiconductor dies are disposed, wherein the pins jut out beyond the housing.

According to an embodiment of a method for forming a power semiconductor module having a plurality of pins, the method comprises: attaching the plurality of pins and one or more power semiconductor dies to a first side of a substrate to form a power semiconductor subassembly; aligning a distal end of each of the pins with an alignment feature of an electrically insulative housing using a jig; and after the aligning, attaching the housing to the power semiconductor subassembly such that the housing and the substrate together define an interior space in which the pins and the one or more power semiconductor dies are disposed, wherein the pins jut out beyond the housing, wherein the aligning comprises: placing the housing on the jig such that the alignment feature of the housing mates with a first alignment feature of the jig; and placing the power semiconductor subassembly on the housing such that the distal end of each of a subset of the pins mates with a second alignment feature of the jig.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIGS. 1A and 1B illustrate a method for attaching a plurality of pins and one or more power semiconductor dies to a substrate to form a power semiconductor subassembly, according to an embodiment.
FIGS. 2A-2C illustrate a method for placing an electrically insulative housing on a jig, according to an embodiment.
FIGS. 3A-3C illustrate a method for aligning a distal end of each of a plurality of pins of a power semiconductor subassembly with an alignment feature of an electrically insulative housing using a jig and attaching the electrically insulative housing to the power semiconductor subassembly, according to an embodiment.
FIGS. 4A and 4B illustrate top-down plan views of a power semiconductor module, according to embodiments.
FIGS. 5A and 5B illustrate perspective views of a power semiconductor module, according to embodiments.
FIG. 6 illustrates an assembly of a power semiconductor module and a component, according to an embodiment.

### DETAILED DESCRIPTION

Described herein are methods for forming a power semiconductor module that includes a plurality of pins. The pins are configured to interface with an external component of an application (e.g., a printed circuit board (PCB)) and provide an electrical interface for the power semiconductor module. Some portions of the assembly process of the power semiconductor module with the external component of the application may be automated. An automated assembly process may use external features of the power semiconductor module, for example features, surfaces, etc., of a housing, as a reference system for aligning the power semiconductor module with the component of the application. Misalignment of the pins relative to this reference system may increase the complexity of the process of assembling the power semiconductor module with the component, as misaligned pins may not properly mate with corresponding openings of the component and may require manual handling to form a proper interface. In some instances, misalignment of the pins exceeding certain tolerances of the application may render the power semiconductor module unusable for the application.

According to embodiments described herein, a jig is used to align each of the pins with an alignment feature of a housing before attaching the housing to a power semiconductor subassembly that includes the pins and one or more power semiconductor dies attached to a substrate. Aligning the pins with the housing when forming a power semiconductor module in accordance with the methods described herein may, in some examples, increase the likelihood that the pins will properly interface with a component (e.g., a PCB) when integrating the power semiconductor module into a target application. Such improved alignment of the pins may even enable this portion of the assembly process of the power semiconductor module with the external component to be completed using an automated process. Specifically, sufficiently accurate alignment of the pins with the housing may enable the assembly of the power semiconductor module and the component using an automated assembly system that is configured to pick up the power semiconductor module by gripping the housing, align the pins with receiving holes of the component using the housing as a positional reference point, and insert the pins into the receiving holes of the component. Such an automated process may provide a simpler, more cost-effective process for manufacturing the power semiconductor module.

Described next, with reference to the figures, are exemplary embodiments of a method for increasing overall pin alignment accuracy when forming a power semiconductor module.

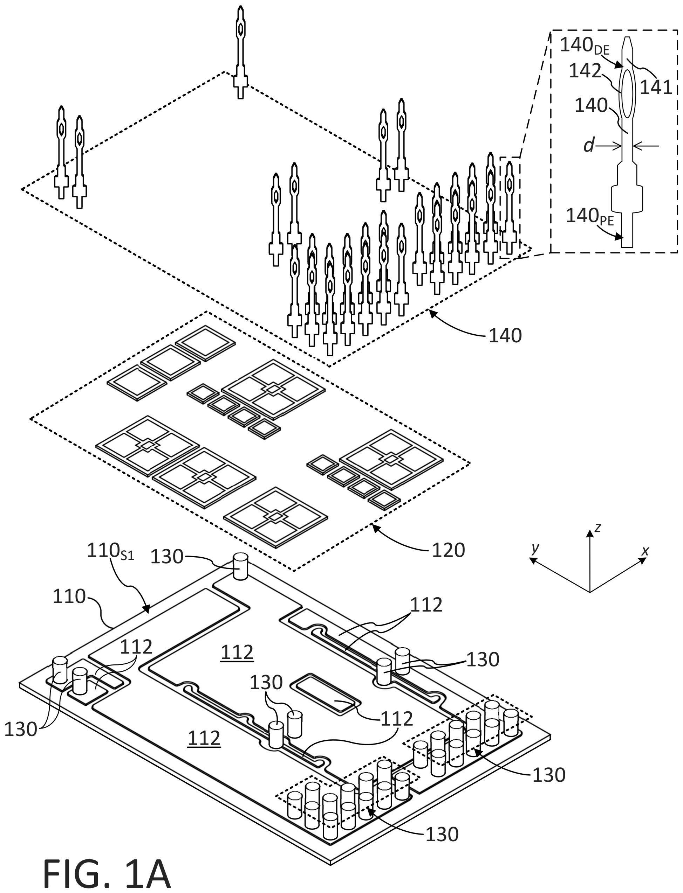

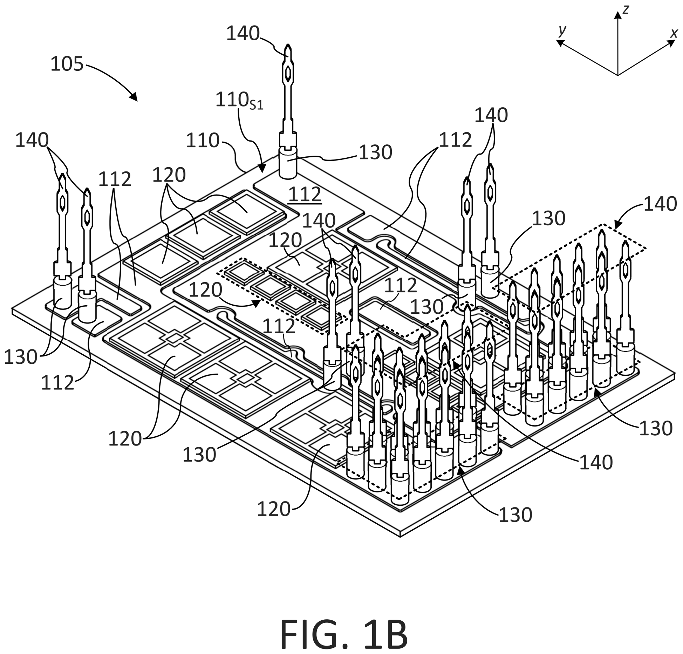

FIGS. 1A and 1B illustrate a method for attaching a plurality of pins 140 and one or more power semiconductor dies 120 to a substrate 110 to form a power semiconductor subassembly 105, according to an embodiment.

Examples of the substrate 110 include a DCB (direct copper bonded) or AMB (active metal brazed) substrate, printed circuit board (PCB), lead frame, or other substrate, e.g., insulated metal substrate (IMS), etc. The substrate 110 may include one or more insulating layers and/or metallization layers. An insulating layer may include a ceramic, a polymer such as polyimide, etc. A metallization layer may include copper, aluminum, an alloy, etc., and may include one or more traces and/or contact pads. The substrate 110 of FIGS. 1A and 1B includes a metallization layer 112 on a first side 110_{S1} of the substrate 110.

Each power semiconductor die 120 may include one or more devices, e.g., one or more transistors, diodes, resistors, capacitors, and/or other types of active or passive devices. One or more of the power semiconductor dies 120 may be a vertical power semiconductor die (e.g., a vertical power transistor die). For a vertical power transistor die, the primary current flow path is between the front and back sides of the power semiconductor die 120 (along the z direction in FIG. 1). In one embodiment, one or more of the power semiconductor dies 120 are SiC transistor dies such as SiC power MOSFET (metal-oxide-semiconductor field-effect transistor) dies. One or more of the power semiconductor dies 120 may be a Si power MOSFET die, HEMT (high-electron mobility transistor) die, IGBT (insulated-gate bipolar transistor) die, JFET (junction filed-effect transistor) die, etc. In examples where more than one power semiconductor die 120 is attached to the substrate 110, the power semiconductor dies 120 may all be of a similar or identical design (e.g., device type, structure, materials, dimensions, etc.), or some or each of the power semiconductor dies 120 may have different designs. Various arrangements of designs of power semiconductor dies 120 on the substrate 110 are contemplated. For example, one or more power semiconductor dies 120 may be arranged on the substrate 110 to form all or part of a circuit of a power semiconductor module, such as a DC/AC inverter, a DC/DC converter, an AC/DC converter, a DC/AC converter, an AC/AC converter, a multi-phase inverter, an H-bridge, motor driver, etc. In some examples, a circuit that includes one or more of the power semiconductor dies 120 is a half-bridge or full-bridge circuit.

The pins 140 may be formed of copper, aluminum, an alloy (e.g., a nickel tin alloy), or another electrically conductive material. As noted previously, the pins 140 provide an electrical interface for the power semiconductor module, with each pin 140 configured to interface with a component (e.g., a PCB) of the application into which the power semiconductor module will be integrated. Each pin 140 may have a diameter d that is measured perpendicular to a longitudinal extension of the pin 140 (e.g., perpendicular to the z direction of FIGS. 1A and 1B). In some examples, a diameter d of each of the pins 140 is less than 1 millimeter. In this example, a distal end 140_{DE} of each pin 140 is a press-fit end that includes a tip part 141 and a deformable part 142 adjoining the tip part 141. For such a configuration, the tip part 141 of the pin 140 may be inserted into a hole of a PCB or other type of substrate and the deformable part 142 may plastically and/or elastically deform when pressed against the walls of the hole, thus securing the pin 140 to the substrate. Other configurations of the pins 140 and means of interfacing the pins 140 with a component are contemplated. For example, the distal ends 140_{DE} of the pins 140 may be soldered to a component such as a PCB.

In the example of FIGS. 1A and 1B, a plurality of sleeves 130 are attached to the first side 110_{S1} of the substrate 110. The sleeves 130 may be formed of a metal or metal alloy such as copper, aluminum, etc. In some examples, one or more sleeves 130 include an electrically insulative cover or coating. In this embodiment, the sleeves 130 are attached to the metallization layer 112, although one or more of the sleeves 130 may be attached to a different metallization layer or other parts of the substrate 110. The sleeves 130 may be attached to the substrate 110 (e.g., the metallization 112 layer or another metallization layer) by soldering (e.g., using soft solder, using solder paste), adhering, welding, etc. Each sleeve 130 is configured to receive a pin 140 and may electrically couple the received pin 140 to one or more power semiconductor dies 120 (e.g., through the metallization layer 112), although other means of attaching the pins 140 to the substrate 110 and electrically coupling the pins 140 to the power semiconductor die(s) 120 without using sleeves 130 are contemplated (e.g., soldering). That is, the sleeves 130 of the embodiments herein are optional and are not a requirement of the disclosed method.

FIG. 1B illustrates attaching the pins 140 and the power semiconductor die(s) 120 to the first side 110_{S1} of the substrate 110 to form the power semiconductor subassembly 105. The power semiconductor die(s) 120 in this example are attached to the metallization layer 112, although one or more of the power semiconductor dies 120 may be attached to a different metallization layer or other parts of the substrate 110. The power semiconductor die(s) 120 may be attached to the substrate 110 (e.g., the metallization layer 112 or another metallization layer) by soldering, diffusion soldering, brazing, adhering, etc.

The pins 140 are attached to the substrate 110 by inserting each pin 140 (e.g., a proximal end 140_{PE} of each pin 140) into a corresponding sleeve 130 attached to the substrate 110. The proximal end 140_{PE} of a respective pin 140 may be press fit into the corresponding sleeve 130. In some examples, the proximal end 140_{PE} of a given pin 140 is soldered to the corresponding sleeve 130.

The remainder of this disclosure describes a method for increasing the alignment accuracy of the pins 140 when forming the power semiconductor module. Specifically, the method disclosed herein includes using a jig to align the distal end 140_{DE} of each of the pins 140 with an alignment feature of an electrically insulative housing before attaching the housing to the power semiconductor subassembly 105 of FIGS. 1A and 1B.

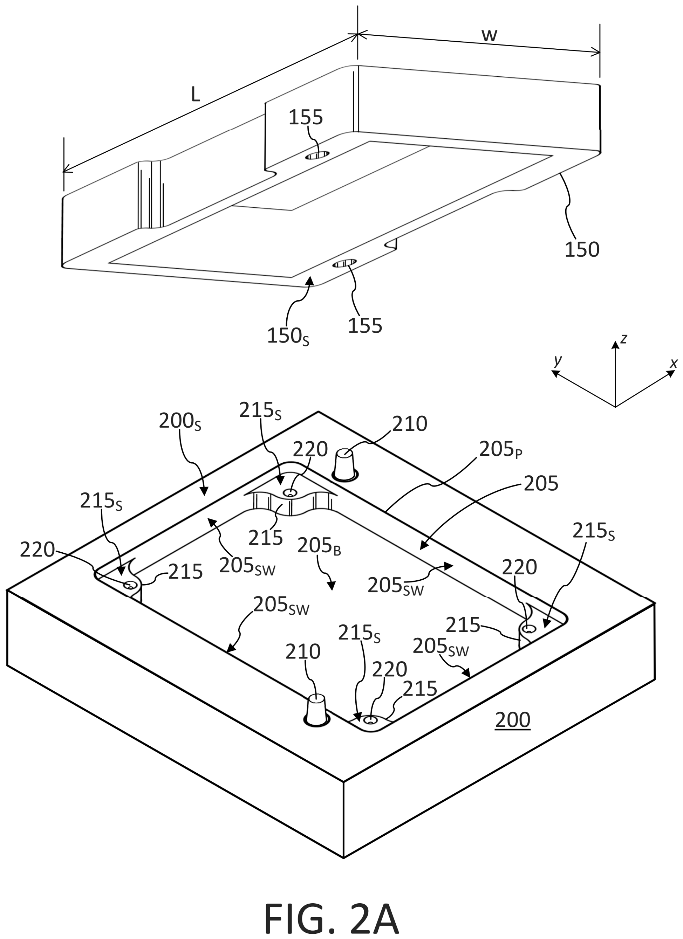

FIGS. 2A-2C illustrate a method for placing an electrically insulative housing 150 on a jig 200, according to an embodiment.

The housing 150 may include one or more pieces of metal, plastic, composite, and/or other suitable material. The housing 150 has a length L and a width w. In some examples, the length L of the housing 150 is less than 100 millimeters. In some examples, the width w of the housing 150 is less than 100 millimeters.

The housing 150 may be a molded enclosure (e.g., a frame) that is formed from a mold compound. A mold compound is a plastic encapsulant typically formed from an organic resin such as an epoxy resin. The plastic encapsulant may include fillers such as non-melting inorganic materials. Catalysts may be used to accelerate the cure reaction of the organic resin. Other materials such as flame retardants, adhesion promoters, ion traps, stress relievers, colorants, etc. may be added to the plastic encapsulant, as appropriate. The mold compound may be formed by injection molding, compression molding, film-assisted molding (FAM), reaction injection molding (RIM), resin transfer molding (RTM), blow molding, etc.

According to an embodiment, the housing 150 includes an alignment feature 155. In this example, the alignment feature 155 includes at least two apertures 155 formed in the housing 150. The apertures 155 extend into the housing 150 from an external surface 150_{S}. Hereafter, the terms alignment feature 155 and aperture(s) 155 may be used interchangeably as appropriate, however this is only one example and other embodiments of the alignment feature 155 are contemplated (e.g., posts).

The jig 200 may be formed from any suitable material (e.g., metal, plastic, ceramic, etc.). The jig 200 includes a cavity 205 that is defined by an opening 205_{P}, a base 205_{B}, a sidewall 205_{SW}, and at least two sidewall features 215 that extend from the base 205_{B} and the sidewall 205_{SW}. The jig 200 of FIG. 2A includes four sidewall features 215, one in each corner of the cavity 205. Each of the sidewall features 215 includes an exterior facing surface 215_{S} that is recessed from the opening 205_{P}. The opening 205_{P} is coincident with and laterally enclosed by an outer perimetrical surface 200_{S} of the jig 200.

According to an embodiment, the jig 200 includes a first alignment feature 210 and a second alignment feature 220. The first alignment feature 210 of the jig 200 is disposed on the outer perimetrical surface 200_{S}. In this example, the first alignment feature 210 of the jig 200 includes two posts 210, although other embodiments of the first alignment feature 210 are contemplated (e.g., more than two posts 210, apertures). Hereafter, the terms first alignment feature 210 and posts 210 may be used interchangeably as appropriate. In the example of the jig 200 of FIG. 2A, the posts 210 are tapered, although this is not a requirement and other geometries of the posts 210 are contemplated. The second alignment feature 220 of the jig 200 is disposed in the cavity 205. In this example, the second alignment feature 220 of the jig 200 includes an aperture 220 formed in the exterior facing surface 215_{S} of each sidewall feature 215, although other positions of the second alignment feature 220 are contemplated. Hereafter, the terms second alignment feature 220 and aperture(s) 220 may be used interchangeably as appropriate.

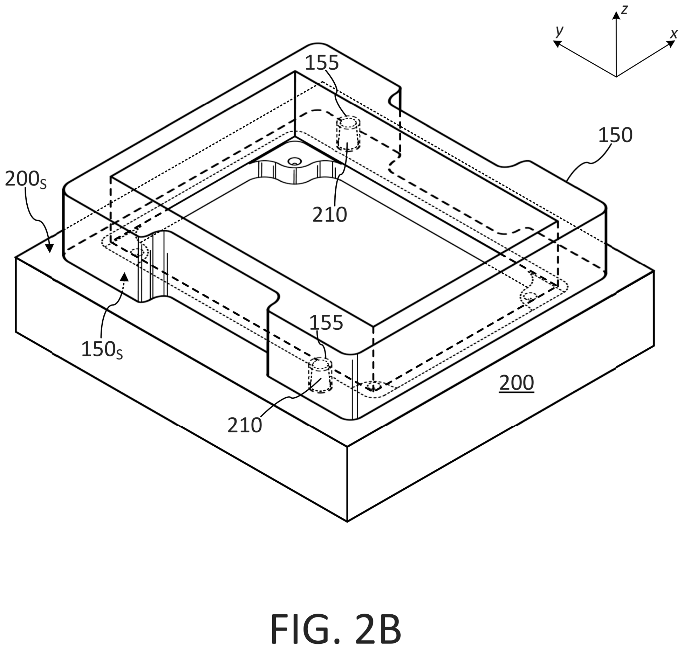

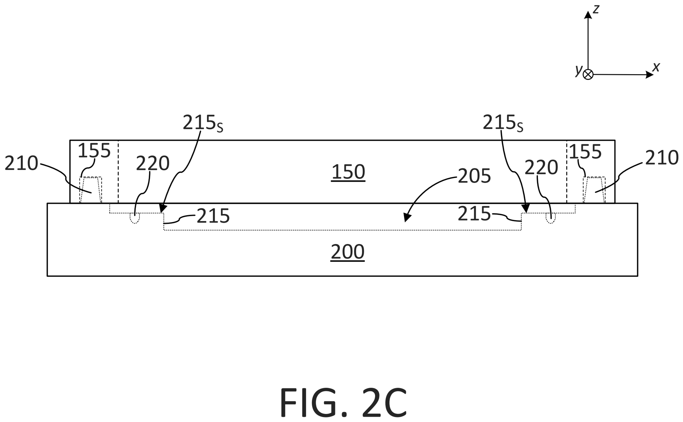

FIGS. 2B and 2C illustrate placing the housing 150 on the jig 200. The housing 150 is placed on the jig 200 with the external surface 150_{S} of the housing facing the outer perimetrical surface 200_{S} of the jig 200. Placing the housing 150 on the jig 200 includes inserting each of the posts 210 of the jig 200 into a corresponding aperture 155 of the housing 150. That is, the housing 150 is placed on the jig 200 such that the alignment feature 155 of the housing 150 mates with the first alignment feature 210 of the jig 200. With the alignment feature 155 of the housing 150 mated with the first alignment feature 210 of the jig 200, the second alignment feature 220 of the jig 200 is aligned to the alignment feature 155 of the housing 150 in the x and y directions.

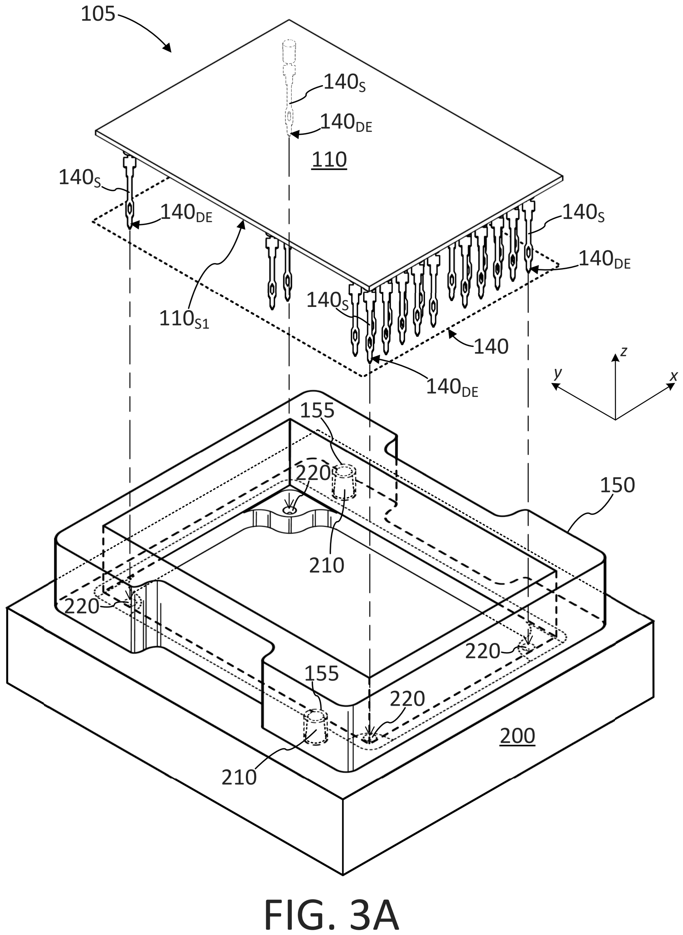

FIGS. 3A-3C illustrate a method for aligning the distal end 140_{DE} of each of the plurality of pins 140 of the power semiconductor subassembly 105 with the alignment feature 155 of the housing 150 using the jig 200 and attaching the housing 150 to the power semiconductor subassembly 105, according to an embodiment.

FIG. 3A illustrates vertically aligning (e.g., along the z direction) each pin 140_{S} of a subset 140_{S} of the pins 140 with a corresponding aperture 220 of the jig 200. In this example, the subset 140_{S} of the pins 140 includes each of the four corner pins 140_{S} attached to the substrate 110.

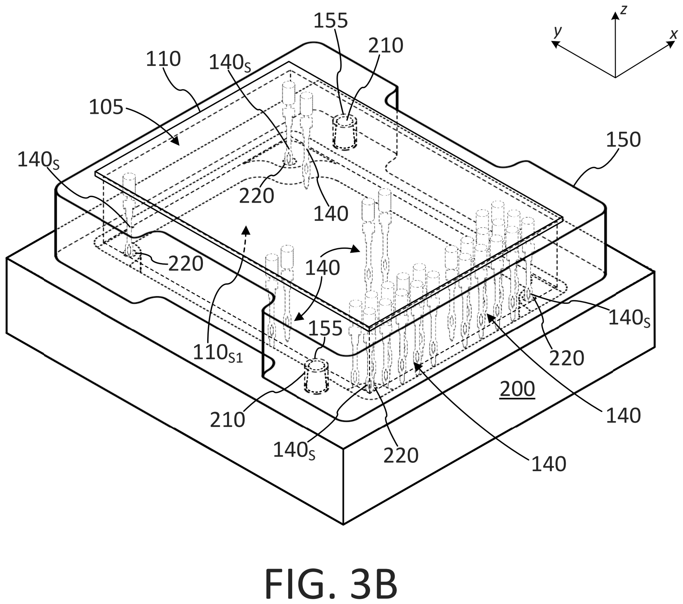

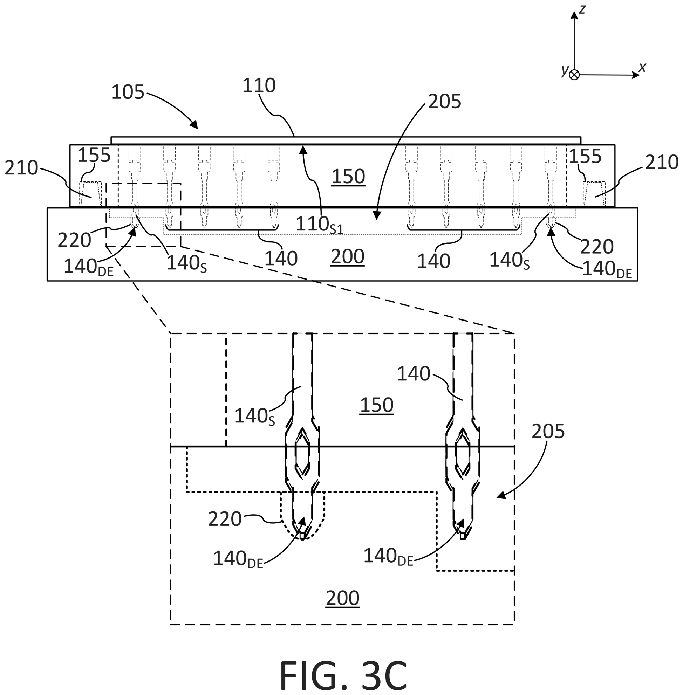

FIGS. 3B and 3C illustrate placing the power semiconductor subassembly 105 on the housing 150, which includes inserting each distal end 140_{DE} of the subset 140_{S} of the pins 140 into a corresponding aperture 220 of the jig 200. That is, the power semiconductor subassembly 105 is placed on the housing 150 such that the distal end 140_{DE} of each of the subset 140_{S} of the pins 140 mates with the second alignment feature 220 of the jig 200. As illustrated in FIG. 3C, the apertures 220 of the jig 200 may be tapered to facilitate the positioning of the pins 140 in the *x* and *y* directions when the power semiconductor subassembly 105 is placed on the housing 150. With the power semiconductor subassembly 105 placed on the housing 150, each pin 140 not included in the subset 104_{S} of the pins 140 is received by the cavity 205 of the jig 200.

With the alignment feature 155 of the housing 150 mated with the first alignment feature 210 of the jig 200 and the distal end 140_{DE} of each of the subset 140_{S} of pins 140 mated with the second alignment feature 220 of the jig 200, the pins 140 are aligned to the alignment feature 155 of the housing 150 in the x and y directions. After the aligning of the pins 140 with the alignment feature 155 of the housing 150, the housing 150 is attached (e.g., by gluing) to the power semiconductor subassembly 105. In the example of FIGS. 3B and 3C, the housing 150 is attached to the first side 110_{S1} of the substrate 110.

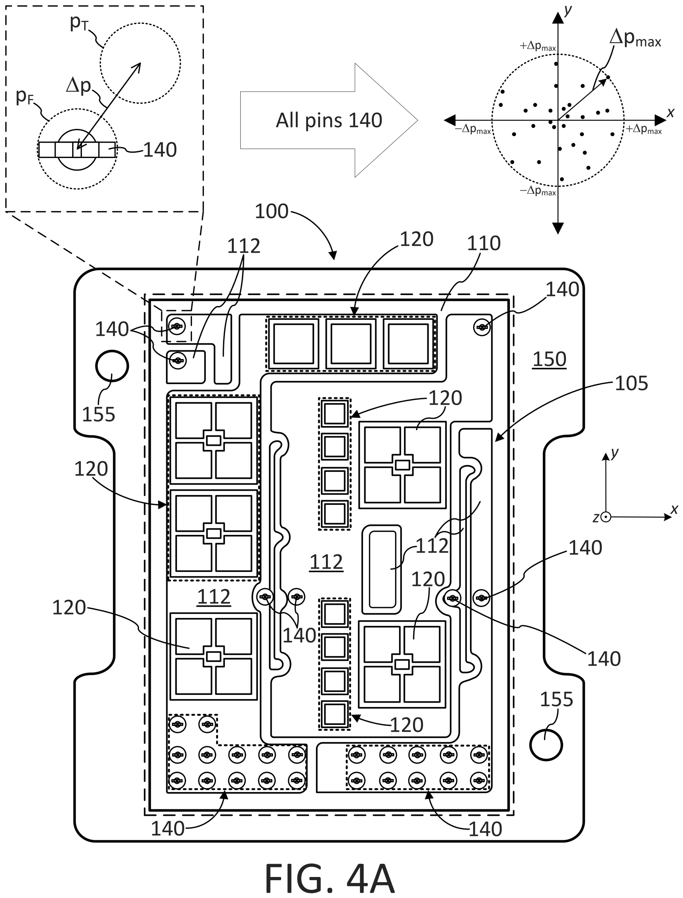

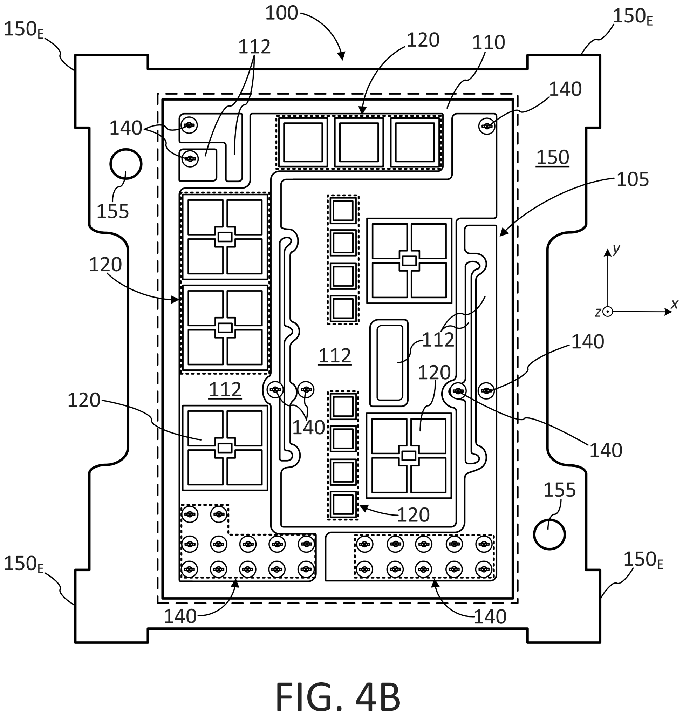

FIGS. 4A and 4B illustrate top-down plan views of a power semiconductor module 100, according to embodiments. The power semiconductor module 100 is one example of a power semiconductor module that may be formed using the steps illustrated in and described with reference to FIGS. 1A-3C of this disclosure. The power semiconductor module 100 includes the housing 150 attached to the power semiconductor subassembly 105, with the pins 140 aligned with the alignment feature 155 of the housing according to the methods illustrated in and described with reference to FIGS. 2A-3C.

FIG. 4A illustrates an example of a target position p_{T} and a final position p_{F} of a pin 140, where Δp represents the deviation (e.g., in the x and y directions) of the final position p_{F} of the pin 140 from the target position p_{T} of the pin 140. Each pin 140 of the power semiconductor module 100 has a target position p_{T}, a final position p_{F}, and a deviation Δp. The deviation Δp in the x and y directions of each of the pins 140 of the power semiconductor module 100 is illustrated on the axes in FIG. 4A.

The target position p_{T} of each pin 140 may be measured relative to a reference system and may correspond to a target position of the pin 140 for a given application of the power semiconductor module. The reference system may include features of the housing 150, including the alignment feature 155, edges/surfaces/corners of the housing 150, screw holes of the housing 150, etc., and may be used for alignment purposes when assembling the power semiconductor module 100 with a component of a target application (e.g., gripping the housing, aligning the housing 150 with the component). Thus, aligning the pins 140 with the housing 150 using the methods disclosed herein may ensure that the pins 140 are also aligned with the reference system, potentially facilitating assembly of the power semiconductor module 100 with the component of the target application. By aligning the pins 140 to the alignment feature 155 of the housing 150 according to the methods disclosed herein, the deviation Δp of a final position p_{F} of each pin 140 from its respective target position p_{T} may be less than, e.g., 0.4 millimeters in both the x-direction and the y-direction relative to the reference system. Stated another way, a maximum of the deviations Δp of all of the pins 140 of the power semiconductor module 100, indicated by Δpₘₐₓ on the axes in FIG. 4A, may be less than, e.g., 0.4 millimeters.

FIG. 4B illustrates an example in which the housing 150 of the power semiconductor module 100 includes external surface features 150_{E} at each corner. The external surface features 150_{E} of FIG. 4B are one example of external surface features that may be part of the reference system used for alignment purposes when assembling the power semiconductor module 100 with a component of a target application. The external surface features 150_{E} of FIG. 4B may, for example, be used as a gripping surface for picking up the power semiconductor module 100 (e.g., with an automated assembly system) when assembling the power semiconductor module 100 with a component of a target application. By aligning the pins 140 to the alignment feature 155 of the housing 150 according to the methods disclosed herein, the pins 140 are also aligned to the external surface features 150_{E} of the housing 150, which may facilitate insertion of the pins 140 into receiving holes of the component (e.g., holes in a PCB).

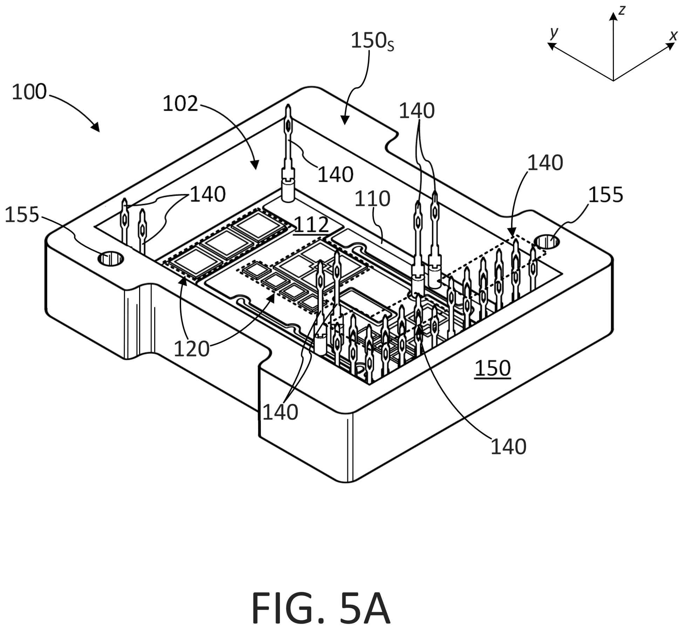

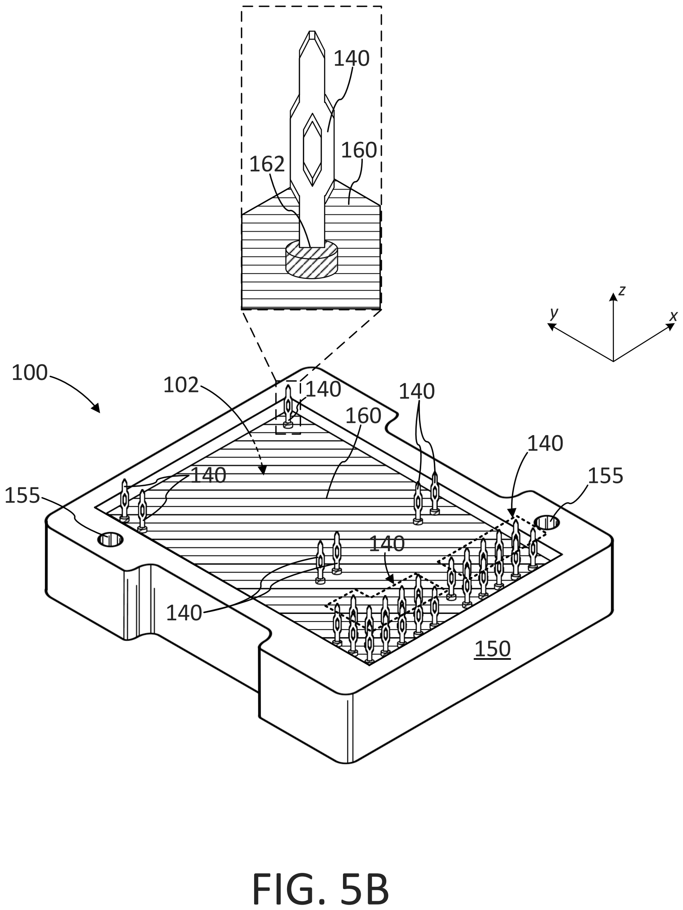

FIGS. 5A and 5B illustrate perspective views of the power semiconductor module 100, according to embodiments. After the aligning of the pins 140 with the alignment feature 155 of the housing 150 and attaching the housing 150 to the power semiconductor subassembly 105 (e.g., to the first side 110_{S1} of the substrate), the housing 150 and the substrate 110 together define an interior space 102 in which the pins 140 and the power semiconductor die(s) 120 are disposed. The pins 140 jut out beyond the housing 150 (e.g., beyond the external surface 150_{S}), providing a means for interfacing the pins 140 with a component of a target application. Aligning the pins 140 to the alignment feature 155 of the housing 150 according to the methods disclosed herein may facilitate insertion of the pins 140 into receiving holes of a component (e.g., holes in a PCB) when integrating the power semiconductor module 100 into a target application.

FIG. 5B illustrates an example in which the method disclosed herein further includes attaching a lid 160 to the housing 150. Alternatively, the lid 160 may be attached to the power semiconductor subassembly 105. The lid 160 further defines the interior space 102 in which the pins 140 and the power semiconductor die(s) 120 are disposed. Each of the pins 140 juts out beyond the housing 150 through an opening 162 in the lid 160.

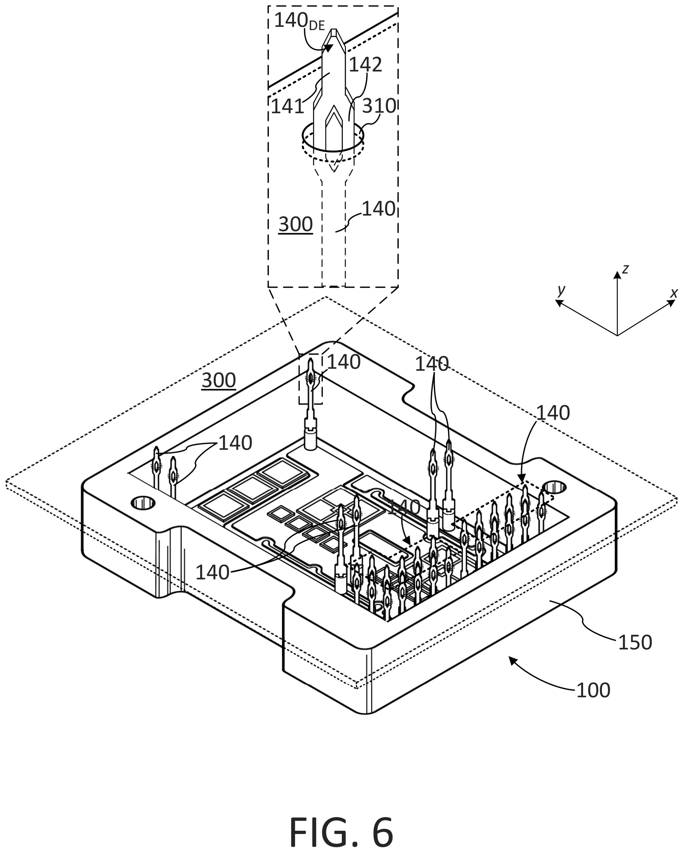

FIG. 6 illustrates an assembly 10 of the power semiconductor module 100 and a component 300, according to an embodiment. The component 300, such as a PCB, includes openings 310 that correspond to the target positions of the pins 140 of the power semiconductor module 100. The power semiconductor module 100 and the component 300 are assembled by inserting the distal end 140_{DE} of each of the pins 140 into a corresponding opening 310 of the component 300. While FIG. 6 illustrates press-fit pins 140 as illustrated and described with reference to FIG. 1A, the pins 140 may assembled with the component 300 by other means, e.g., soldering.

Accurate alignment of the pins 140 with the housing 150 may ensure that the pins 140 can be properly inserted into the openings 310 when assembling the power semiconductor module 100 and the component 300. As noted previously, the assembly process can potentially be automated if the pins 140 are sufficiently aligned within an acceptable tolerance with a reference system that includes features of the housing 150. Thus, forming the power semiconductor module 100 according to the methods disclosed herein may ensure sufficiently accurate alignment of the pins 140 relative to the housing 150 to enable automated assembly of the power semiconductor module 100 and the component 300, potentially providing a more cost-effective manufacturing process.

Although the present disclosure is not so limited, the following numbered examples demonstrate one or more aspects of the disclosure.

Example 1. A method for increasing overall pin alignment accuracy for a power semiconductor module having a plurality of pins, the method comprising: attaching the plurality of pins and one or more power semiconductor dies to a first side of a substrate to form a power semiconductor subassembly; aligning a distal end of each of the pins with an alignment feature of an electrically insulative housing using a jig; and after the aligning, attaching the housing to the power semiconductor subassembly such that the housing and the substrate together define an interior space in which the pins and the one or more power semiconductor dies are disposed, wherein the pins jut out beyond the housing.

Example 2. The method of example 1, wherein the aligning comprises: placing the housing on the jig such that the alignment feature of the housing mates with a first alignment feature of the jig; and placing the power semiconductor subassembly on the housing such that the distal end of each of a subset of the pins mates with a second alignment feature of the jig.

Example 3. The method of example 2, wherein the jig comprises an outer perimetrical surface that is coincident with and laterally encloses an opening of a cavity of the jig, wherein the first alignment feature of the jig is disposed on the outer perimetrical surface, and wherein the second alignment feature of the jig is disposed in the cavity of the jig.

Example 4. The method of example 2 or 3, wherein the alignment feature of the housing comprises at least two apertures formed in the housing, wherein the first alignment feature of the jig comprises at least two posts, and wherein placing the housing on the jig comprises inserting each of the at least two posts of the jig into a corresponding aperture of the at least two apertures of the housing.

Example 5. The method of example 4, wherein the at least two posts of the jig are tapered.

Example 6. The method of any of examples 2 through 5, wherein the second alignment feature of the jig comprises an aperture formed in each of at least two sidewall features of the jig, and wherein placing the power semiconductor subassembly on the housing comprises inserting each distal end of the subset of the pins into a corresponding aperture formed in the at least two sidewall features of the jig.

Example 7. The method of example 6, wherein the at least two sidewall features of the jig partly define a cavity of the jig, and wherein with the power semiconductor subassembly placed on the housing, each pin not included in the subset of the pins is received by the cavity of the jig.

Example 8. The method of example 7, wherein the cavity of the jig is further defined by a base and a sidewall, and wherein each of the at least two sidewall features of the jig extends from the base and the sidewall.

Example 9. The method of example 7 or 8, wherein the cavity of the jig is further defined by an opening that is coincident with and laterally enclosed by an outer perimetrical surface of the jig, wherein the aperture formed in each of the at least two sidewall features of the jig is formed in an exterior facing surface of the sidewall feature, and wherein the exterior facing surface of each of the at least two sidewall features is recessed from the opening.

Example 10. The method of any of examples 6 through 9, wherein the aperture formed in the at least two sidewall features of the jig is tapered.

Example 11. The method of any of examples 1 through 10, wherein attaching the housing to the power semiconductor subassembly comprises gluing.

Example 12. The method of any of examples 1 through 11, further comprising attaching a lid to the housing and/or the power semiconductor subassembly, wherein the lid further defines the interior space in which the pins and the one or more power semiconductor dies are disposed, and wherein each of the pins juts out beyond the housing through an opening in the lid.

Example 13. The method of any of examples 1 through 12, wherein after attaching the housing to the power semiconductor subassembly, a final position of each pin deviates from a target position by less than 0.4 millimeters in both the x-direction and the y-direction relative to a reference system.

Example 14. The method of any of examples 1 through 13, wherein at least one of a length or a width of the housing in a dimension that is substantially parallel to the substrate is less than 100 millimeters.

Example 15. The method of any of examples 1 through 14, wherein a diameter of each of the pins is less than 1 millimeters.

Example 16. A method for forming a power semiconductor module having a plurality of pins, the method comprising: attaching the plurality of pins and one or more power semiconductor dies to a first side of a substrate to form a power semiconductor subassembly; aligning a distal end of each of the pins with an alignment feature of an electrically insulative housing using a jig; and after the aligning, attaching the housing to the power semiconductor subassembly such that the housing and the substrate together define an interior space in which the pins and the one or more power semiconductor dies are disposed, wherein the pins jut out beyond the housing, wherein the aligning comprises: placing the housing on the jig such that the alignment feature of the housing mates with a first alignment feature of the jig; and placing the power semiconductor subassembly on the housing such that the distal end of each of a subset of the pins mates with a second alignment feature of the jig.

Example 17. The method of example 16, wherein the jig comprises outer perimetrical surface that is coincident with and laterally encloses an opening of a cavity of the jig, wherein the first alignment feature of the jig is disposed on the outer perimetrical surface, and wherein the second alignment feature of the jig is disposed in the cavity of the jig.

Example 18. The method of example 16 or 17, wherein after attaching the housing to the power semiconductor subassembly, a final position of each pin deviates from a target position by less than 0.4 millimeters in both the x-direction and the y-direction relative to a reference system.

Example 19. The method of any of examples 16 through 18, wherein at least one of a length or a width of the housing in a dimension that is substantially parallel to the substrate is less than 100 millimeters.

Example 20. The method of any of examples 16 through 19, wherein a diameter of each of the pins is less than 1 millimeters.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to include all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B.

It is to be understood that the features of the various embodiments described herein can be combined with each other, unless specifically noted otherwise.

Although specific embodiments have been illustrated and described herein, it will be appreciated by those of ordinary skill in the art that a variety of alternate and/or equivalent implementations can be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method for increasing overall pin alignment accuracy for a power semiconductor module (100) having a plurality of pins (140), the method comprising:
attaching the plurality of pins (140) and one or more power semiconductor dies (120) to a first side of a substrate (110) to form a power semiconductor subassembly (105);
aligning a distal end (140_{DE}) of each of the pins (140) with an alignment feature (155) of an electrically insulative housing (150) using a jig (200); and
after the aligning, attaching the housing (150) to the power semiconductor subassembly (105) such that the housing (150) and the substrate (110) together define an interior space (102) in which the pins (140) and the one or more power semiconductor dies (120) are disposed,
wherein the pins (140) jut out beyond the housing (150).

2. The method of claim 1, wherein the aligning comprises:
placing the housing (150) on the jig (200) such that the alignment feature (155) of the housing (150) mates with a first alignment feature (210) of the jig (200); and
placing the power semiconductor subassembly (105) on the housing (150) such that the distal end (140_{DE}) of each of a subset of the pins (140) mates with a second alignment feature (220) of the jig (200).

3. The method of claim 2,
wherein the jig (200) comprises an outer perimetrical surface (200_{S}) that is coincident with and laterally encloses an opening (205_{P}) of a cavity (205) of the jig (200),
wherein the first alignment feature (210) of the jig (200) is disposed on the outer perimetrical surface (200_{S}), and
wherein the second alignment feature (220) of the jig (200) is disposed in the cavity (205) of the jig (200).

4. The method of claim 2 or 3, wherein the alignment feature (155) of the housing (150) comprises at least two apertures (155) formed in the housing (150), wherein the first alignment feature (210) of the jig (200) comprises at least two posts (210), and wherein placing the housing (150) on the jig (200) comprises inserting each of the at least two posts (210) of the jig (200) into a corresponding aperture of the at least two apertures (155) of the housing (150).

5. The method of claim 4, wherein the at least two posts (210) of the jig (200) are tapered.

6. The method of any of claims 2 to 5, wherein the second alignment feature (220) of the jig (200) comprises an aperture formed in each of at least two sidewall features (215) of the jig (200), and wherein placing the power semiconductor subassembly (105) on the housing (150) comprises inserting each distal end (140_{DE}) of the subset of the pins (140) into a corresponding aperture formed in the at least two sidewall features (215) of the jig (200).

7. The method of claim 6, wherein the at least two sidewall features (215) of the jig (200) partly define a cavity (205) of the jig (200), and wherein with the power semiconductor subassembly (105) placed on the housing (150), each pin not included in the subset of the pins (140) is received by the cavity (205) of the jig (200).

8. The method of claim 7, wherein the cavity (205) of the jig (200) is further defined by a base (205_{B}) and a sidewall (205_{SW}), and wherein each of the at least two sidewall features (215) of the jig (200) extends from the base (205_{B}) and the sidewall (205_{SW}).

9. The method of claim 7 or 8,
wherein the cavity (205) of the jig (200) is further defined by an opening (205_{P}) that is coincident with and laterally enclosed by an outer perimetrical surface (200_{S}) of the jig (200),
wherein the aperture formed in each of the at least two sidewall features (215) of the jig (200) is formed in an exterior facing surface (215_{S}) of the sidewall feature (215), and
wherein the exterior facing surface (215_{S}) of each of the at least two sidewall features (215) is recessed from the opening (205_{P}).

10. The method of any of claims 6 to 9, wherein the aperture formed in the at least two sidewall features (215) of the jig (200) is tapered.

11. The method of any of claims 1 to 10, wherein attaching the housing (150) to the power semiconductor subassembly (105) comprises gluing.

12. The method of any of claims 1 to 11, further comprising attaching a lid (160) to the housing (150) and/or the power semiconductor subassembly (105), wherein the lid (160) further defines the interior space (102) in which the pins (140) and the one or more power semiconductor dies (120) are disposed, and wherein each of the pins (140) juts out beyond the housing (150) through an opening (162) in the lid (160).

13. The method of any of claims 1 to 12, wherein after attaching the housing (150) to the power semiconductor subassembly (105), a final position of each pin (140) deviates from a target position by less than 0.4 millimeters in both the x-direction and the y-direction relative to a reference system.

14. The method of any of claims 1 to 13, wherein
at least one of a length or a width of the housing (150) in a dimension that is substantially parallel to the substrate (110) is less than 100 millimeters, and/or
a diameter of each of the pins (140) is less than 1 millimeters.

15. A method for forming a power semiconductor module (100) having a plurality of pins (140), the method comprising:
attaching the plurality of pins (140) and one or more power semiconductor dies (120) to a first side of a substrate (110) to form a power semiconductor subassembly (105);
aligning a distal end (140_{DE}) of each of the pins (140) with an alignment feature (155) of an electrically insulative housing (150) using a jig (200); and
after the aligning, attaching the housing (150) to the power semiconductor subassembly (105) such that the housing (150) and the substrate (110) together define an interior space (102) in which the pins (140) and the one or more power semiconductor dies (120) are disposed,
wherein the pins (140) jut out beyond the housing (150),
wherein the aligning comprises:
placing the housing (150) on the jig (200) such that the alignment feature (155) of the housing (150) mates with a first alignment feature (210) of the jig (200); and
placing the power semiconductor subassembly (105) on the housing (150) such that the distal end (140_{DE}) of each of a subset of the pins (140) mates with a second alignment feature (220) of the jig (200).
